(19) Europäisches Patentamt
European Patent Office
Office européen des brevets

(11) EP 4 726 084 A1

(12) **EUROPEAN PATENT APPLICATION**

(43) Date of publication:
**15.04.2026 Bulletin 2026/16**

(21) Application number: **25202701.6**

(22) Date of filing: **17.09.2025**

(51) International Patent Classification (IPC):
**D03C 19/00** (2006.01)   **G06F 30/20** (2020.01)

(52) Cooperative Patent Classification (CPC):
**D03C 19/005; G06F 30/20**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **11.10.2024 IN 202421077311**

(71) Applicant: **Tata Consultancy Services Limited Maharashtra (IN)**

(72) Inventors:
• **IYYAMVEETTIL, Aswin**
  **603103 Chennai, Tamil Nadu (IN)**

• **MEPPADATH VINOD, Dhanil**
  **682042 Kochi, Kerala (IN)**
• **NAIR, Abhishek Santhosh**
  **603103 Chennai, Tamil Nadu (IN)**
• **SRIDHAR, Priyadharshini**
  **600096 Chennai, Tamil Nadu (IN)**
• **KOKKU NAGA VENKATA, Durgaprasad**
  **600096 Chennai, Tamil Nadu (IN)**
• **SRINIVASAN, Raman**
  **600096 Chennai, Tamil Nadu (IN)**
• **SRINIVASAN, Swarna**
  **600096 Chennai, Tamil Nadu (IN)**

(74) Representative: **Goddar, Heinz J.**
  **Boehmert & Boehmert**
  **Anwaltspartnerschaft mbB**
  **Pettenkoferstrasse 22**
  **80336 München (DE)**

(54) **METHOD AND SYSTEM TO VERIFY AND RECONFIGURE DESIGN VALUES OF RECONFIGURABLE JACQUARD CARDS**

(57)    Conventionally, validating a configured jacquard card is manual, difficult and time-consuming process. Automated techniques require complex and costly hardware setup. Embodiments of present disclosure provide a method and system to verify and reconfigure design values of reconfigurable jacquard cards. It obtains a design from user and generates reference images of patterns required to weave the design. The user then configures the jacquard card based on the reference images and scans them after configuration. Patterns in the scanned images are validated against the reference images by identifying position of first top left hole and iteratively verifying the remaining holes by traversing one hole at a time and comparing its pixel value with that of the reference image. If the user has to create a new design using the same set of configured jacquard cards, order of the cards to be used for reconfiguring the new design with minimal cost is suggested.

FIG. 2

# EP 4 726 084 A1

**Description**

## CROSS-REFERENCE TO RELATED APPLICATIONS AND PRIORITY

The present application claims priority to Indian application no. 202421077311, filed on October 11, 2024.

## TECHNICAL FIELD

The present invention generally relates to the field of weaving of textiles, and, more particularly, to a method and system to verify and reconfigure design values of reconfigurable jacquard cards.

## BACKGROUND

Reconfigurable jacquard cards can be configured for a weaving design by filling pins into holes in the cards. Currently, the configured jacquard card is validated manually by comparing with the design or motif image pixel by pixel for each hole in the jacquard card. This is a difficult and time-consuming process. When a weaver has to reconfigure the cards from a first design to a second design, the weaver has to manually compare each card of the first design to every card of the second design and change the pin positions to reconfigure the cards to the second design. This involves a lot of manual effort and is prone to errors that will significantly affect the final design on the fabric. Some of the automated techniques available in the art to verify design on punched cards are implemented using embedded system with light sensors for data retrieval and error detection implying a more complex and potentially costlier setup. These systems are fixed installations, limiting portability and flexibility. They also require specialized knowledge to operate and maintain the embedded system and sensors. Further, if a weaver has to migrate the cards from one motif to another, currently the only way is to undo the current design configuration for each card and redo the new design configuration. This is also a very effort intensive job.

## SUMMARY

Embodiments of the present disclosure present technological improvements as solutions to one or more of the above-mentioned technical problems recognized by the inventors in conventional systems. For example, in one embodiment, a method to verify and reconfigure design values of reconfigurable jacquard cards is provided. The method includes obtaining a first user selected design of a motif to be weaved on a fabric and generating a first set of reference images associated with a first set of jacquard card patterns required to weave the first user selected design. Further, the method includes obtaining a plurality of images of a first set of reconfigurable jacquard cards that are configured with the first set of jacquard card patterns. The method further includes validating each of the plurality of images with the first set of reference images by identifying an x-coordinate and a y-coordinate of a first top left hole in each of the plurality of images and iteratively verifying each hole in each of the plurality of images. At each iteration, position of a next hole is calculated based on a x-coordinate and a y-coordinate of a previous hole by incrementing value of the x-coordinate of the previous hole by a first value and the y-coordinate of the previous hole by a second value. The identified x-coordinate and the identified y-coordinate of the first top left hole are used in first iteration. Then, a pixel color value at the calculated position of the next hole is compared with a pixel color value of corresponding hole in an associated reference image.

In another aspect, a system to verify and reconfigure design values of reconfigurable jacquard cards is provided. The system includes: a memory storing instructions; one or more communication interfaces; and one or more hardware processors coupled to the memory via the one or more communication interfaces, wherein the one or more hardware processors are configured by the instructions to obtain a first user selected design of a motif to be weaved on a fabric and generating a first set of reference images associated with a first set of jacquard card patterns required to weave the first user selected design. Further, the one or more hardware processors are configured by the instructions to obtain a plurality of images of a first set of reconfigurable jacquard cards that are configured with the first set of jacquard card patterns. The one or more hardware processors are configured by the instructions to validate each of the plurality of images with the first set of reference images by identifying an x-coordinate and a y-coordinate of a first top left hole in each of the plurality of images and iteratively verify each hole in each of the plurality of images. At each iteration, position of a next hole is calculated based on a x-coordinate and a y-coordinate of a previous hole by incrementing value of the x-coordinate of the previous hole by a first value and the y-coordinate of the previous hole by a second value. The identified x-coordinate and the identified y-coordinate of the first top left hole are used in first iteration. Then, a pixel color value at the calculated position of the next hole is compared with a pixel color value of corresponding hole in an associated reference image.

In yet another aspect, there are provided one or more non-transitory machine-readable information storage mediums comprising one or more instructions which when executed by one or more hardware processors cause a method to verify and reconfigure design values of reconfigurable jacquard cards. The method includes obtaining a first user selected design of a motif to be weaved on a fabric and generating a first set of reference images associated with a first set of jacquard card patterns required to weave the first user selected design. Further, the method includes obtaining a plurality of images of a first set of reconfigurable jacquard cards that are configured with the first set of jacquard card patterns. The method further includes validating each of the plurality of images with the first set of reference images by identifying an x-coordinate and a y-coordinate of a first top left hole in each of the plurality of images and iteratively verifying each hole in each of the plurality of images. At each iteration, position of a next hole is calculated based on a x-coordinate and a y-coordinate of a previous hole by incrementing value of the x-coordinate of the previous hole by a first value and the y-coordinate of the previous hole by a second value. The identified x-coordinate and the identified y-coordinate of the first top left hole are used in first iteration. Then, a pixel color value at the calculated position of the next hole is compared with a pixel color value of corresponding hole in an associated reference image.

It is to be understood that both the foregoing general description and the following detailed description are exemplary and explanatory only and are not restrictive of the invention, as claimed.

BRIEF DESCRIPTION OF THE DRAWINGS

The accompanying drawings, which are incorporated in and constitute a part of this disclosure, illustrate exemplary embodiments and, together with the description, serve to explain the disclosed principles:

FIG. 1 illustrates an exemplary block diagram of a system to verify and reconfigure design values of reconfigurable jacquard cards, according to some embodiments of the present disclosure.
FIG. 2 is a flow diagram illustrating a method to verify and reconfigure design values of reconfigurable jacquard cards, executed using the system of FIG. 1, according to some embodiments of the present disclosure.
FIG. 3 illustrates an example rectangle detected in an image of the reconfigurable jacquard card and its associated measurements used to verify design values of the reconfigurable jacquard card, according to some embodiments of the present disclosure.
FIG. 4 illustrates an example output of method of FIG. 2, according to some embodiments of the present disclosure.

DETAILED DESCRIPTION OF EMBODIMENTS

Exemplary embodiments are described with reference to the accompanying drawings. In the figures, the left-most digit(s) of a reference number identifies the figure in which the reference number first appears. Wherever convenient, the same reference numbers are used throughout the drawings to refer to the same or like parts. While examples and features of disclosed principles are described herein, modifications, adaptations, and other implementations are possible without departing from the scope of the disclosed embodiments.

Conventionally, validating a configured jacquard card involves lot of human efforts and therefore difficult and time-consuming process. Some of the automated techniques require complex and costly hardware setup. Embodiments of present disclosure provide a method and system to verify and reconfigure design values of reconfigurable jacquard cards. The method obtains a design from a user and generates reference images of jacquard card patterns required to weave the design. The user then configures the jacquard card by referring to the reference images and scans the jacquard cards after configuration. Design in the scanned images are validated against the reference images by first identifying position of first top left hole and iteratively verifying the remaining holes by traversing one hole at a time and comparing its pixel value with that of the reference image. If the user has to create a new design using the same set of configured jacquard cards, the method suggests order of the cards to be used for reconfiguring the new design with minimal cost.

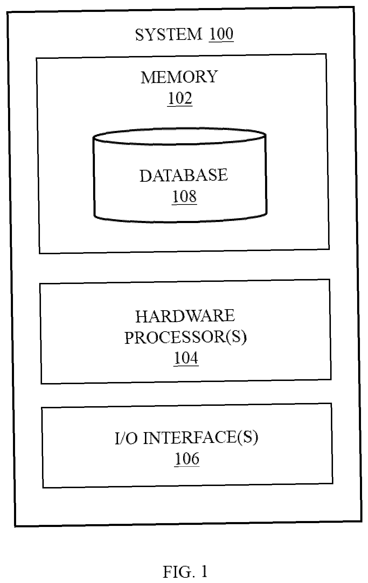

Referring now to the drawings, and more particularly to FIGS. 1 to 4, where similar reference characters denote corresponding features consistently throughout the figures, there are shown preferred embodiments, and these embodiments are described in the context of the following exemplary system and/or method.

FIG. 1 illustrates an exemplary block diagram of a system to verify and reconfigure design values of reconfigurable jacquard cards, according to some embodiments of the present disclosure. In an embodiment, the system 100 includes one or more processors 104, communication interface device(s) 106 or Input/Output (I/O) interface(s) 106 or user interface 106, and one or more data storage devices or memory 102 operatively coupled to the one or more processors 104. The one or more processors 104 that are hardware processors can be implemented as one or more microprocessors, microcomputers, microcontrollers, digital signal processors, central processing units, state machines, logic circuitries, and/or any devices that manipulate signals based on operational instructions. Among other capabilities, the processor(s) is configured to fetch and execute computer-readable instructions stored in the memory. In an embodiment, the system 100 can be implemented in a variety of computing systems, such as laptop computers, notebooks, hand-held devices, workstations, mainframe computers, servers, a network cloud, and the like.

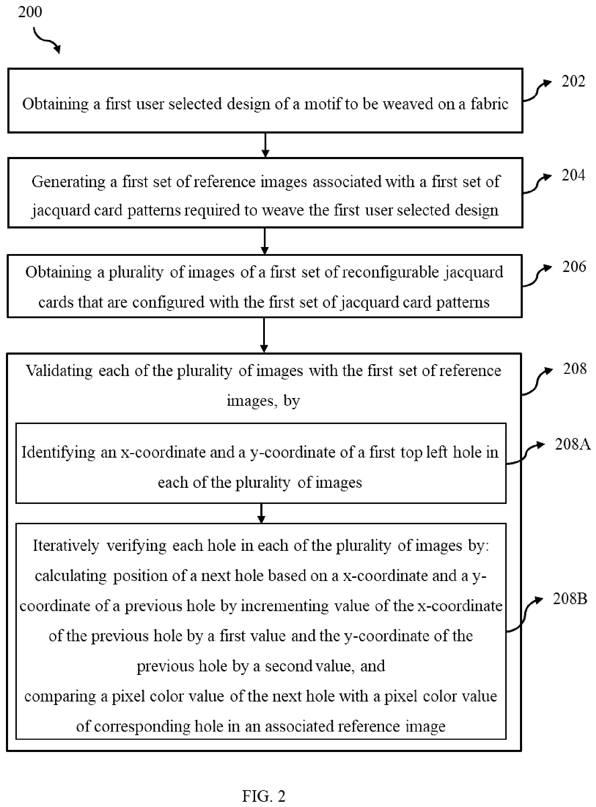

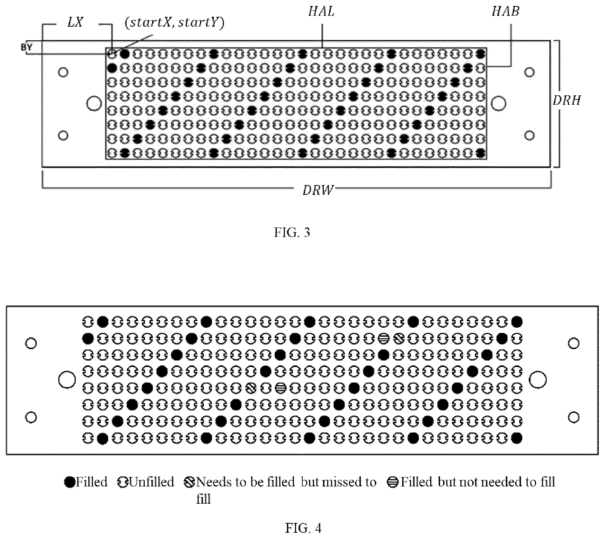

The I/O interface device(s) 106 can include a variety of software and hardware interfaces, for example, a web interface, a graphical user interface, and the like and can facilitate multiple communications within a wide variety of networks N/W and protocol types, including wired networks, for example, LAN, cable, etc., and wireless networks, such as WLAN, cellular, or satellite. The memory 102 may include any computer-readable medium known in the art including, for example, volatile memory, such as Static Random-Access Memory (SRAM) and Dynamic Random-Access Memory (DRAM), and/or non-volatile memory, such as read only memory (ROM), erasable programmable ROM, flash memories, hard disks, optical disks, and magnetic tapes. The database 108 stores information pertaining to inputs fed to the system 100 and/or outputs generated by the system (e.g., at each stage), specific to the methodology described herein. Functions of the components of system 100 are explained in conjunction with flow diagram depicted in FIG. 2 and examples illustrated in FIGS. 3 and 4 to verify and reconfigure design values of reconfigurable jacquard cards.

In an embodiment, the system 100 comprises one or more data storage devices or the memory 102 operatively coupled to the processor(s) 104 and is configured to store instructions for execution of steps of the method 200 depicted in FIG. 2 by the processor(s) or one or more hardware processors 104. The steps of the method of the present disclosure will now be explained with reference to the components or blocks of the system 100 as depicted in FIG. 1, the steps of flow diagram depicted in flow diagram of FIG. 2 and examples illustrated in FIGS. 3 and 4, to verify and reconfigure design values of reconfigurable jacquard cards. Although process steps, method steps, techniques or the like may be described in a sequential order, such processes, methods, and techniques may be configured to work in alternate orders. In other words, any sequence or order of steps that may be described does not necessarily indicate a requirement that the steps be performed in that order. The steps of processes described herein may be performed in any order practical. Further, some steps may be performed simultaneously.

FIG. 2 is a flow diagram illustrating a method to verify and reconfigure design values of reconfigurable jacquard cards, executed using the system of FIG. 1, according to some embodiments of the present disclosure. At step 202, the one or more hardware processors 104 are configured to obtain a first user selected design of a motif to be weaved on a fabric. Further, at step 204 of the method 200, the one or more hardware processors 104 are configured to generate a first set of reference images associated with a first set of jacquard card patterns required to weave the first user selected design. The first set of reference images are generated by converting the selected design image into binary data. Then the user configures a first set of reconfigurable jacquard cards (such as the one disclosed in patent application number 202221064714) by inserting a plurality of snap pins within perforations in the reconfigurable jacquard card according to the first set of reference images. Before using these configured jacquard cards for weaving the first design on a fabric, the user has to ensure that the plurality of snap pins are placed at the right locations, otherwise, it may lead to weaving incorrect design on the fabric. Thus, the user scans or clicks images of the configured first set of reconfigurable jacquard cards via the I/O interfaces 106. Further, at step 206 of the method 200, the one or more hardware processors 104 are configured to obtain a plurality of images of a first set of reconfigurable jacquard cards that are configured with the first set of jacquard card patterns.

Once the plurality of images are obtained, at step 208 of the method 200, the one or more hardware processors 104 are configured to validate each of the plurality of images with the first set of reference images by performing steps 208A and 208B. At the step 208A, an x-coordinate and a y-coordinate of a first top left hole are identified in each of the plurality of images. As illustrated in FIG. 3, *(startX, startY)* represent coordinates of the first top left hole. They are identified by firstly determining coordinates of a plurality of corners of a jacquard card in the image using an edge detection technique (available in libraries such as OpenCV) and detecting a rectangle in the image based on the coordinates of the plurality of corners. Once the rectangle is detected, it is preprocessed to obtain a preprocessed detected rectangle. Preprocessing involves matching length and breadth ratio of the detected rectangle with that of physical reconfigurable jacquard card. Next, the detected rectangle is cropped from the image. If the cropped image is skewed, it is stretched to make sure it is having same length and breadth on both sides. Once preprocessing is completed, a Detected Rectangle Width *(DRW)* and a Detected Rectangle Height *(DRH)* are calculated from the preprocessed detected rectangle. *DRW* is nothing but the width of the preprocessed detected rectangle and *DRH* is the height of the preprocessed detected rectangle. Then the x-coordinate *(startX)* of the first top left hole of the jacquard card in the image is determined according to equation 1, wherein *DRW* is the detected rectangle width, *LX* is a distance from a top left corner of a physical reconfigurable jacquard card to center of a first top left hole in the physical reconfigurable jacquard card length wise (as illustrated in FIG. 3), and *CL* is an actual length of the physical reconfigurable jacquard card. The y-coordinate *(startY)* of the first top left hole in the jacquard card in the image is determined according to equation 2, wherein *DRH* is the Detected Rectangle Height, *BY* is distance from the top left corner of the physical reconfigurable jacquard card to center of the first top left hole in the physical reconfigurable jacquard card breadth wise (as illustrated in FIG. 3), and *CB* is an actual breadth of the physical reconfigurable jacquard card.

$$startX \;=\; (DRW \,*\, LX) \,/\, CL \qquad \dots (1)$$

$$startY \;=\; (DRH \,*\, BY) \,/\, CB \qquad \dots (2)$$

Once *startX* and *startY* are identified, at the step 208B, each hole in each of the plurality of images is verified by calculating position of a next hole based on a x-coordinate and a y-coordinate of a previous hole by incrementing value of the x-coordinate of the previous hole by a first value (alternatively referred to as Incremental X-Value *(IXV))* and the y-coordinate of the previous hole by a second value (alternatively referred to as Incremental Y-Value (IYV)) and comparing a pixel color value at the calculated position of the next hole with a pixel color value of corresponding hole in an associated reference image. The identified x-coordinate and the identified y-coordinate of the first top left hole are used in first iteration.

In an embodiment, the first value and the second value are determined by firstly determining a Hole Area Length *(HAL)* by equation 3 and determining a Hole Area Breadth *(HAB)* by equation 4. *HAL* is total length of an area where holes are present in the preprocessed detected rectangle. *HAB* is total breadth of the area where holes are present in the preprocessed detected rectangle. Once *HAL* and *HAB* are determined, the first value *(IXV)* and the second value *(IYV)* are calculated according to equations 5 and 6, respectively. *RHC* is a number of holes in a row of the jacquard card and *CHC* is a number of holes in a column of the jacquard card.

$$HAL = DRW - (startX * 2) \qquad ..... (3)$$

$$HAB = DRH - (startY * 2) \qquad ..... (4)$$

$$IXV = HAL \ / \ RHC \qquad ..... (5)$$

$$IYV = HAB \ / \ CHC \qquad ..... (6)$$

Thus, at step 208B design value is verified hole by hole. FIG. 4 illustrates an example output of method of FIG. 2, according to some embodiments of the present disclosure. The holes that are filled, unfilled, missed to be filled according to reference image and filled by mistake are shown to user. The user can then make appropriate corrections required according to the reference image by inserting or removing the snap pins wherever necessary.

After weaving the first design, if the user (weaver) wants to weave a new design using the first set of jacquard cards, a particular order of the first set of jacquard cards has to be determined such that they can be reconfigured to the new design with minimal changes/cost. In order to achieve this, a second user selected design of a motif to be weaved on a fabric is obtained and a second set of reference images associated with a second set of jacquard card patterns required to weave the second user selected design are generated. Next, an order of the first set of reconfigurable jacquard cards needed to obtain the second set of jacquard card patterns for reconfiguring the first set of reconfigurable jacquard cards with a minimal cost is determined, by firstly generating a plurality of binary string representations of the first set of reference images and a plurality of binary string representations of the second set of reference images. In the plurality of binary string representations, value 0 represents an empty hole and value 1 represents a filled hole. Next, a cost matrix is computed based on a hamming distance between (i) each of the plurality of binary string representations of the first set of reference images, and (ii) each of the plurality of binary string representations of the second set of reference images. Further, a plurality of permutations of the second set of jacquard card patterns is generated. Each permutation gives a specific order of jacquard cards in the second set of jacquard card patterns. Cost of each permutation is determined by using the cost matrix and the permutation with least cost is selected.

Example implementation: Suppose binary string representations of two cards A and B are: A= 100101, B=111101, then, the hamming distance is 2. Assume $C_1$, $C_2$, ..., $C_{n1}$ are the binary string representations of the first set of reconfigurable jacquard cards and $D_1$, $D_2$, ..., $D_{n2}$ are binary string representations of the second set of jacquard card patterns, then, table 1 illustrate an example cost matrix.

Table 1

|          | $C_1$ | $C_2$ | $C_3$ | $C_4$ | ..... | $C_{n1}$ |
|----------|-------|-------|-------|-------|-------|----------|
| $D_1$    | 0     | 0     | 0     | 2     |       |          |
| $D_2$    | 0     | 3     | 21    | 2     |       |          |
| $D_3$    | 4     | 9     | 37    | 0     |       |          |
| $D_4$    | 240   | 240   | 240   | 3     |       |          |
| :        |       |       |       |       |       |          |
| $D_{n2}$ |       |       |       |       |       |          |

Consider only the first 4 cards C1, C2, C3, C4 as first set and D1, D2, D3, D4 as second set. Different permutations of these cards are created, and corresponding costs are calculated. For example, the index of cards in set 2 are (3, 2, 1 ,4) i.e. cards D3, D2, D1 and D4 are mapped to cards C1, C2, C3, C4 in set 1 representing the minimum total cost is 10. Another permutation (1, 2, 3, 4) corresponding to cards D1, D2, D3, D4 which get mapped to cards C1, C2, C3 and C4, gives a minimum total cost of 43. All such permutations of index of cards in set 2 need to considered and total cost for each of these combinations is to be determined from the cost matrix. Out of all the cost, the permutation with the minimum cost is selected. Following is the pseudocode for determining the order of first set of cards to be reconfigured with minimal cost:

Step 0: Perm(n2) = List of all permutations of indices of cards in the second set D1 to Dn2. This is a list as follows [(1,2,3,4), (1,2,4,3), (1,3,2,4), (1,3,4,2), (1,4,3,2), (1,4,2,3), and so on.] There would be 24 permutations in the list.
Step 1: Create an empty list of 24 permutations, which will later hold the minimum cost of that permutation.
For each Perm(n2), initialise empty list of Tot_CostPerm_j= []
Step 2: Calculate the minimum cost of each permutation and append to the list
For i in 1 to n1:
For perm_j belongs in 1 to Perm(n2):

Assign Tot_CostPerm_j=0
Find index j with min of Cost (Ci, Dj)
Tot_CostPerm_j= Min Cost (Ci, D2j)
Step 3: Append j to a memory list
Remove car Dj from list of Cards

$$\text{Append Tot\_CostPerm\_j} = \text{Tot\_CostPerm\_j} + \text{ min of Cost (Ci, Dj)}$$

Step 4:
Repeat step 2 and 3 till all cards i in first set are picked up, matched to cards in second set and exhausted
Return Tot_Cost perm_j
Repeat for all perms(n2).
Collect all the total_Cost of each perm_j and return the least in the list.

Suppose the second set of jacquard card patterns are not known in advance, then, a greedy approach is taken to determine changes needed to reconfigure the first set of reconfigurable jacquard cards. In the greedy approach, the user can pick any jacquard card in any order from the existing set of cards and tie up from set C which has jacquard cards represented by strings C1... Cn1. For example, if the user picks up the cards in the order C2, C3, C4, and C1 from the first set, the method recommends a card from the second set with the least hamming distance. For E.g., the C2 card will be changed to D1 as it has the least distance of 0. C3 will be matched by pattern D2 with least distance of 21. C4 will be matched by D3 with least distance of 0. C1 will be matched by D4 with least distance of 240. A total cost is calculated by summing up the distance of individual card choices. i.e., 0+21+0+240=261. As is visible, the choice of the card order from the first set determines the immediate choice of the cards from the second set. This minimizes the total cost to a certain extent but is not the best possible option that can be computed if the card order in the first set were known ahead and there is no change in the order in which the cards from first set are picked. This is thus a greedy approach. Following is the pseudocode for greedy approach:

Step 1: Initialise Tot_Cost = 0
Step 2: For each card with index Ci picked up randomly by the user from among C1 to Cn1:
Search each card Dj (j in 1 to n2) in the second set:

Find Dj which is the index of card belonging to second set with the lease distance. If there are more than one such index, choose the first.
Find index j with min of Cost (Ci, Dj).
Step 3: Append card Dj to a memory list.
Remove card Dj from second set since it has been consumed.

$$\text{Append Tot\_Cost} = \text{Tot\_Cost} + \text{ min of Cost (Ci, Dj)}$$

Step 4:
Repeat step 2 and 3 till all cards Ci in first set are picked up, matched to cards Dj in second set and are exhausted.

Return Tot_Cost

In an embodiment, the method 200 is implemented as an Android application on a handheld device such as mobile phone. This provides significant benefits in terms of usability and cost savings as listed below-

1. Error Reduction: The mobile app ensures accuracy by verifying reconfigured cards and suggesting optimal configurations. This minimizes manual errors, reducing the need for rework and further saving time and costs.
2. Better Resource Allocation: The app's ability to suggest the best possible card configurations means that resources are used more efficiently. This ensures that the available cards are utilized to their fullest potential, maximizing productivity.
3. Labor Savings: Automation of the verification and suggestion process reduces the need for skilled labor to manually check and configure cards, lowering labor costs and allowing workers to focus on more value-added tasks.
4. Increased Design Flexibility: The ability to quickly reconfigure cards enables designers to experiment and innovate without the constraint of high costs for new cards. This fosters creativity and can lead to more competitive and unique product offerings.
5. Scalability: The solution is scalable across different textile manufacturing setups, making it a viable investment for companies of various sizes and ensuring long-term economic benefits.

The written description describes the subject matter herein to enable any person skilled in the art to make and use the embodiments. The scope of the subject matter embodiments is defined by the claims and may include other modifications that occur to those skilled in the art. Such other modifications are intended to be within the scope of the claims if they have similar elements that do not differ from the literal language of the claims or if they include equivalent elements with insubstantial differences from the literal language of the claims.

It is to be understood that the scope of the protection is extended to such a program and in addition to a computer-readable means having a message therein; such computer-readable storage means contain program-code means for implementation of one or more steps of the method, when the program runs on a server or mobile device or any suitable programmable device. The hardware device can be any kind of device which can be programmed including e.g., any kind of computer like a server or a personal computer, or the like, or any combination thereof. The device may also include means which could be e.g., hardware means like e.g., an application-specific integrated circuit (ASIC), a field-programmable gate array (FPGA), or a combination of hardware and software means, e.g., an ASIC and an FPGA, or at least one microprocessor and at least one memory with software processing components located therein. Thus, the means can include both hardware means, and software means. The method embodiments described herein could be implemented in hardware and software. The device may also include software means. Alternatively, the embodiments may be implemented on different hardware devices, e.g., using a plurality of CPUs.

The embodiments herein can comprise hardware and software elements. The embodiments that are implemented in software include but are not limited to, firmware, resident software, microcode, etc. The functions performed by various components described herein may be implemented in other components or combinations of other components. For the purposes of this description, a computer-usable or computer readable medium can be any apparatus that can comprise, store, communicate, propagate, or transport the program for use by or in connection with the instruction execution system, apparatus, or device.

The illustrated steps are set out to explain the exemplary embodiments shown, and it should be anticipated that ongoing technological development will change the manner in which particular functions are performed. These examples are presented herein for purposes of illustration, and not limitation. Further, the boundaries of the functional building blocks have been arbitrarily defined herein for the convenience of the description. Alternative boundaries can be defined so long as the specified functions and relationships thereof are appropriately performed. Alternatives (including equivalents, extensions, variations, deviations, etc., of those described herein) will be apparent to persons skilled in the relevant art(s) based on the teachings contained herein. Such alternatives fall within the scope of the disclosed embodiments. Also, the words "comprising," "having," "containing," and "including," and other similar forms are intended to be equivalent in meaning and be open ended in that an item or items following any one of these words is not meant to be an exhaustive listing of such item or items or meant to be limited to only the listed item or items. It must also be noted that as used herein and in the appended claims, the singular forms "a," "an," and "the" include plural references unless the context clearly dictates otherwise.

Furthermore, one or more computer-readable storage media may be utilized in implementing embodiments consistent with the present disclosure. A computer-readable storage medium refers to any type of physical memory on which information or data readable by a processor may be stored. Thus, a computer-readable storage medium may store instructions for execution by one or more processors, including instructions for causing the processor(s) to perform steps or stages consistent with the embodiments described herein. The term "computer-readable medium" should be understood to include tangible items and exclude carrier waves and transient signals, i.e., be non-transitory. Examples include random access memory (RAM), read-only memory (ROM), volatile memory, non-volatile memory, hard drives, CD ROMs, DVDs, flash drives, disks, and any other known physical storage media.

It is intended that the disclosure and examples be considered as exemplary only, with a true scope of disclosed embodiments being indicated by the following claims.

## Claims

1. A processor implemented method (200), comprising:

   obtaining (202), via one or more hardware processors, a first user selected design of a motif to be weaved on a fabric;
   generating (204), via the one or more hardware processors, a first set of reference images associated with a first set of jacquard card patterns required to weave the first user selected design;
   obtaining (206), via the one or more hardware processors, a plurality of images of a first set of reconfigurable jacquard cards that are configured with the first set of jacquard card patterns; and
   validating (208), via the one or more hardware processors, each of the plurality of images with the first set of reference images, by:

      identifying (208A) a x-coordinate and a y-coordinate of a first top left hole in each of the plurality of images; and
      iteratively verifying (208B) each hole in each of the plurality of images by:

         calculating position of a next hole based on a x-coordinate and a y-coordinate of a previous hole by incrementing value of the x-coordinate of the previous hole by a first value and the y-coordinate of the previous hole by a second value, wherein the identified x-coordinate and the identified y-coordinate of the first top left hole are used in first iteration; and
         comparing a pixel color value at the calculated position of the next hole with a pixel color value of corresponding hole in an associated reference image.

2. The method as claimed in claim 1, wherein identifying the x-coordinate *(startX)* and the y-coordinate *(startY)* of the first top left hole in an image among the plurality of images comprises:

   determining coordinates of a plurality of corners of a jacquard card comprised in the image using an edge detection technique;
   detecting a rectangle in the image based on the coordinates of the plurality of corners;
   preprocessing the detected rectangle to obtain preprocessed detected rectangle;
   calculating a Detected Rectangle Width *(DRW)* and a Detected Rectangle Height *(DRH)* from the preprocessed detected rectangle;
   determining the x-coordinate *(startX)* of the first top left hole of the jacquard card in the image as $startX = (DRW * LX) / CL$, wherein *DRW* is the detected rectangle width, *LX* is a distance from a top left corner of a physical reconfigurable jacquard card to center of a first top left hole in the physical reconfigurable jacquard card length wise, and *CL* is an actual length of the physical reconfigurable jacquard card; and
   determining the y-coordinate *(startY)* of the first top left hole in the jacquard card in the image as: $startY = (DRH * BY) / CB$, wherein *DRH* is the detected rectangle height, *BY* is distance from the top left corner of the physical reconfigurable jacquard card to center of the first top left hole in the physical reconfigurable jacquard card breadth wise, and *CB* is an actual breadth of the physical reconfigurable jacquard card.

3. The method as claimed in claim 2, wherein the first value and the second value are determined by:

   determining a Hole Area Length *(HAL)* as: $HAL = DRW - (startX * 2)$, wherein the *HAL* is total length of an area where holes are present in the preprocessed detected rectangle;
   determining a Hole Area Breadth *(HAB)* as: $HAB = DRH - (startY * 2)$, wherein *HAB* is total breadth of the area where holes are present in the preprocessed detected rectangle;
   calculating the first value as: $HAL / RHC$, wherein *RHC* is a number of holes in a row of the jacquard card; and
   calculating the second value as: $HAB / CHC$, wherein *CHC* is a number of holes in a column of the jacquard card.

4. The method as claimed in claim 1, comprising:

obtaining a second user selected design of a motif to be weaved on a fabric;

generating a second set of reference images associated with a second set of jacquard card patterns required to weave the second user selected design; and

determining an order of the first set of reconfigurable jacquard cards needed to obtain the second set of jacquard card patterns by reconfiguring the first set of reconfigurable jacquard cards with a minimal cost, by:

generating a plurality of binary string representations of the first set of reference images and a plurality of binary string representations of the second set of reference images, wherein in the plurality of binary string representations, value 0 represents an empty hole and value 1 represents a filled hole;

computing a cost matrix based on a hamming distance between (i) each of the plurality of binary string representations of the first set of reference images, and (ii) each of the plurality of binary string representations of the second set of reference images;

generating a plurality of permutations of the second set of jacquard card patterns, wherein each of the plurality of permutations gives a specific order of jacquard cards in the second set of jacquard card patterns;

determining a cost for each of the plurality of permutations based on the cost matrix; and

selecting a permutation having a least cost among the plurality of permutations.

5. A system (100), comprising:

a memory (102) storing instructions;

one or more Input/Output (I/O) interfaces (106); and

one or more hardware processors (104) coupled to the memory (102) via the one or more communication interfaces (106), wherein the one or more hardware processors (104) are configured by the instructions to:

obtain a first user selected design of a motif to be weaved on a fabric;

generate a first set of reference images associated with a first set of jacquard card patterns required to weave the first user selected design;

obtain a plurality of images of a first set of reconfigurable jacquard cards that are configured with the first set of jacquard card patterns; and

validate each of the plurality of images with the first set of reference images, by:

identifying a x-coordinate and a y-coordinate of a first top left hole in each of the plurality of images; and

iteratively verifying each hole in each of the plurality of images by:

calculating position of a next hole based on a x-coordinate and a y-coordinate of a previous hole by incrementing value of the x-coordinate of the previous hole by a first value and the y-coordinate of the previous hole by a second value, wherein the identified x-coordinate and the identified y-coordinate of the first top left hole are used in first iteration; and

comparing a pixel color value at the calculated position of the next hole with a pixel color value of corresponding hole in an associated reference image.

6. The system as claimed in claim 5, wherein the one or more hardware processors are configured to identify the x-coordinate *(startX)* and the y-coordinate *(startY)* of the first top left hole in an image among the plurality of images, by:

determining coordinates of a plurality of corners of a jacquard card comprised in the image using an edge detection technique;

detecting a rectangle in the image based on the coordinates of the plurality of corners;

preprocessing the detected rectangle to obtain a preprocessed detected rectangle;

calculating a Detected Rectangle Width *(DRW)* and a Detected Rectangle Height *(DRH)* from the preprocessed detected rectangle;

determining the x-coordinate *(startX)* of the first top left hole of the jacquard card in the image as $startX = (DRW * LX) / CL$, wherein *DRW* is the detected rectangle width, *LX* is a distance from a top left corner of a physical reconfigurable jacquard card to center of a first top left hole in the physical reconfigurable jacquard card length wise, and *CL* is an actual length of the physical reconfigurable jacquard card; and

determining the y-coordinate *(startY)* of the first top left hole in the jacquard card in the image as: $startY = (DRH * BY) / CB$, wherein *DRH* is the detected rectangle height, *BY* is distance from the top left corner of the physical reconfigurable jacquard card to center of the first top left hole in the physical reconfigurable jacquard card breadth wise, and *CB* is an actual breadth of the physical reconfigurable jacquard card.

7. The system as claimed in claim 6, wherein the one or more hardware processors are configured to determine the first value and the second value by:

determining a Hole Area Length *(HAL)* as: $HAL = DRW - (startX * 2)$, wherein the *HAL* is total length of an area where holes are present in the preprocessed detected rectangle;
determining a Hole Area Breadth *(HAB)* as: $HAB = DRH - (startY * 2)$, wherein *HAB* is total breadth of the area where holes are present in the preprocessed detected rectangle;
calculating the first value as: $HAL / RHC$, wherein *RHC* is a number of holes in a row of the jacquard card; and
calculating the second value as: $HAB / CHC$, wherein *CHC* is a number of holes in a column of the jacquard card.

8. The system as claimed in claim 5, the one or more hardware processors are configured to:

obtain a second user selected design of a motif to be weaved on a fabric;
generate a second set of reference images associated with a second set of jacquard card patterns required to weave the second user selected design; and
determine an order of the first set of reconfigurable jacquard cards needed to obtain the second set of jacquard card patterns by reconfiguring the first set of reconfigurable jacquard cards with a minimal cost, by:

generating a plurality of binary string representations of the first set of reference images and a plurality of binary string representations of the second set of reference images, wherein in the plurality of binary string representations, value 0 represents an empty hole and value 1 represents a filled hole;
computing a cost matrix based on a hamming distance between (i) each of the plurality of binary string representations of the first set of reference images, and (ii) each of the plurality of binary string representations of the second set of reference images;
generating a plurality of permutations of the second set of jacquard card patterns, wherein each of the plurality of permutations gives a specific order of jacquard cards in the second set of jacquard card patterns;
determining a cost for each of the plurality of permutations based on the cost matrix; and
selecting a permutation having a least cost among the plurality of permutations.

9. One or more non-transitory machine-readable information storage mediums comprising one or more instructions which when executed by one or more hardware processors cause:

obtaining a first user selected design of a motif to be weaved on a fabric;
generating a first set of reference images associated with a first set of jacquard card patterns required to weave the first user selected design;
obtaining a plurality of images of a first set of reconfigurable jacquard cards that are configured with the first set of jacquard card patterns; and
validating each of the plurality of images with the first set of reference images, by:
identifying a x-coordinate and a y-coordinate of a first top left hole in each of the plurality of images; and
iteratively verifying each hole in each of the plurality of images by:

calculating position of a next hole based on a x-coordinate and a y-coordinate of a previous hole by incrementing value of the x-coordinate of the previous hole by a first value and the y-coordinate of the previous hole by a second value, wherein the identified x-coordinate and the identified y-coordinate of the first top left hole are used in first iteration; and
comparing a pixel color value at the calculated position of the next hole with a pixel color value of corresponding hole in an associated reference image.

10. The one or more non-transitory machine-readable information storage mediums as claimed in claim 9, wherein identifying the x-coordinate *(startX)* and the y-coordinate *(startY)* of the first top left hole in an image among the plurality of images comprises:

determining coordinates of a plurality of corners of a jacquard card comprised in the image using an edge detection technique;
detecting a rectangle in the image based on the coordinates of the plurality of corners;
preprocessing the detected rectangle to obtain preprocessed detected rectangle;
calculating a Detected Rectangle Width *(DRW)* and a Detected Rectangle Height *(DRH)* from the preprocessed detected rectangle;

determining the x-coordinate *(startX)* of the first top left hole of the jacquard card in the image as *startX = (DRW * LX) / CL,* wherein *DRW* is the detected rectangle width, *LX* is a distance from a top left corner of a physical reconfigurable jacquard card to center of a first top left hole in the physical reconfigurable jacquard card length wise, and *CL* is an actual length of the physical reconfigurable jacquard card; and

determining the y-coordinate *(startY)* of the first top left hole in the jacquard card in the image as: *startY = (DRH * BY) / CB,* wherein *DRH* is the detected rectangle height, *BY* is distance from the top left corner of the physical reconfigurable jacquard card to center of the first top left hole in the physical reconfigurable jacquard card breadth wise, and *CB* is an actual breadth of the physical reconfigurable jacquard card.

11. The one or more non-transitory machine-readable information storage mediums as claimed in claim 10, wherein the first value and the second value are determined by:

determining a Hole Area Length *(HAL)* as: *HAL = DRW - (startX * 2),* wherein the *HAL* is total length of an area where holes are present in the preprocessed detected rectangle;

determining a Hole Area Breadth *(HAB)* as: *HAB = DRH - (startY * 2),* wherein *HAB* is total breadth of the area where holes are present in the preprocessed detected rectangle;

calculating the first value as: *HAL / RHC,* wherein *RHC* is a number of holes in a row of the jacquard card; and

calculating the second value as: *HAB / CHC,* wherein *CHC* is a number of holes in a column of the jacquard card.

12. The one or more non-transitory machine-readable information storage mediums as claimed in claim 9, wherein the one or more instructions which when executed by the one or more hardware processors cause:

obtaining a second user selected design of a motif to be weaved on a fabric;

generating a second set of reference images associated with a second set of jacquard card patterns required to weave the second user selected design; and

determining an order of the first set of reconfigurable jacquard cards needed to obtain the second set of jacquard card patterns by reconfiguring the first set of reconfigurable jacquard cards with a minimal cost, by:

generating a plurality of binary string representations of the first set of reference images and a plurality of binary string representations of the second set of reference images, wherein in the plurality of binary string representations, value 0 represents an empty hole and value 1 represents a filled hole;

computing a cost matrix based on a hamming distance between (i) each of the plurality of binary string representations of the first set of reference images, and (ii) each of the plurality of binary string representations of the second set of reference images;

generating a plurality of permutations of the second set of jacquard card patterns, wherein each of the plurality of permutations gives a specific order of jacquard cards in the second set of jacquard card patterns;

determining a cost for each of the plurality of permutations based on the cost matrix; and

selecting a permutation having a least cost among the plurality of permutations.

SYSTEM 100

MEMORY
102

DATABASE
108

HARDWARE
PROCESSOR(S)
104

I/O INTERFACE(S)
106

FIG. 1

200

202

Obtaining a first user selected design of a motif to be weaved on a fabric

204

Generating a first set of reference images associated with a first set of jacquard card patterns required to weave the first user selected design

206

Obtaining a plurality of images of a first set of reconfigurable jacquard cards that are configured with the first set of jacquard card patterns

208

Validating each of the plurality of images with the first set of reference images, by

208A

Identifying an x-coordinate and a y-coordinate of a first top left hole in each of the plurality of images

208B

Iteratively verifying each hole in each of the plurality of images by: calculating position of a next hole based on a x-coordinate and a y-coordinate of a previous hole by incrementing value of the x-coordinate of the previous hole by a first value and the y-coordinate of the previous hole by a second value, and comparing a pixel color value of the next hole with a pixel color value of corresponding hole in an associated reference image

FIG. 2

LX   (startX, startY)          HAL                    HAB

FIG. 3

●Filled  ◑Unfilled  ⊗Needs to be filled but missed to  ⊖Filled but not needed to fill
fill

FIG. 4

**EUROPEAN SEARCH REPORT**

Application Number

EP 25 20 2701

## DOCUMENTS CONSIDERED TO BE RELEVANT

| Category | Citation of document with indication, where appropriate, of relevant passages | Relevant to claim |
|---|---|---|
| A | JP 2002 302843 A (YAMAMOTO YUKINOJO) 18 October 2002 (2002-10-18) * claims 1-3; figures 1-6 * ----- | 1-12 |
| A | US 3 671 944 A (DUBNER HARVEY) 20 June 1972 (1972-06-20) * figures 1-12 * ----- | 1-12 |
| A | CN 111 177 809 A (NANJING FIBERGLASS RES & DESIGN INSTITUTE CO LTD) 19 May 2020 (2020-05-19) * claims 9,10 * ----- | 5,9 |

**CLASSIFICATION OF THE APPLICATION (IPC)**

INV.
D03C19/00
G06F30/20

**TECHNICAL FIELDS SEARCHED (IPC)**

D03C
G06F

The present search report has been drawn up for all claims

| Place of search | Date of completion of the search | Examiner |
|---|---|---|
| Munich | 4 February 2026 | Iamandi, Daniela |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 25 20 2701

This annex lists the patent family members relating to the patent documents cited in the above-mentioned European search report.
The members are as contained in the European Patent Office EDP file on
The European Patent Office is in no way liable for these particulars which are merely given for the purpose of information.

04-02-2026

| Patent document cited in search report | | Publication date | Patent family member(s) | | Publication date |
|---|---|---|---|---|---|
| JP 2002302843 | A | 18-10-2002 | NONE | | |
| US 3671944 | A | 20-06-1972 | BE | 784795 A | 02-10-1972 |
| | | | US | 3671944 A | 20-06-1972 |
| CN 111177809 | A | 19-05-2020 | CN | 111177809 A | 19-05-2020 |
| | | | EP | 3872678 A1 | 01-09-2021 |
| | | | US | 2022119992 A1 | 21-04-2022 |
| | | | WO | 2021134937 A1 | 08-07-2021 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- IN 202421077311

- WO 202221064714 A